Europäisches Patentamt

European Patent Office

Office européen des brevets

(19)

(11) EP 0 690 578 A1

(12) **EUROPEAN PATENT APPLICATION**

(43) Date of publication:
03.01.1996 Bulletin 1996/01

(51) Int Cl.6: **H03K 19/0185**

(21) Application number: 95108328.6

(22) Date of filing: 31.05.1995

(84) Designated Contracting States:
**DE FR GB**

(30) Priority: **31.05.1994 JP 119110/94**

(71) Applicant: **NEC CORPORATION**
**Tokyo (JP)**

(72) Inventor: **Isono, Toshio, c/o NEC Corporation**
**Tokyo (JP)**

(74) Representative: **Betten & Resch**
**D-80469 München (DE)**

(54) **MOSFET interface circuit having an increased or a reduced mutual conductance**

(57)    In a semiconductor integrated circuit device having an input terminal (19) connected to a first integrated circuit operable with a first voltage and comprising a second integrated circuit (17) connected to an output terminal (51) to be operable with a second voltage lower than the first voltage and an interface circuit comprising first (43) and second (45) MOS FET's connected in series across the second voltage, the interface circuit comprises an n-channel type MOT FET (47) connected between the input terminal and gate electrodes of the first and the second MOS FET's (43,45) and having a gate electrode supplied with a local voltage, which is not higher than the second voltage, and a third MOS FET (53) having a channel type of the first MOS FET (43) and connected in parallel to the first MOS FET (43) with a point of parallel connection connected to the output terminal (51). The first and the second voltages are typically 5 and 3 volts. In any event, the local voltage is preferably equal to the second voltage and may not be lower than about a half of the first voltage. Alternatively, the third MOS FET has the channel type of the second MOS FET (45) and is connected between the second MOS FET (45) and a lower voltage end of the second voltage with the first MOS FET (43) connected between an upper voltage end of the second voltage and the output terminal (51).

Fig.3

## Description

BACKGROUND OF THE INVENTION:

This invention relates to a semiconductor integrated circuit (IC) device which is for connection to a first semiconductor integrated circuit operable with a high voltage or first source voltage, such as 5 volts, and comprises a second semiconductor integrated circuit operable with a low voltage or second source voltage, such as 3 volts, and an interface circuit for use in connecting the first and the second integrated circuits. It is possible to include the first integrated circuit in the integrated circuit device. The integrated circuit device may be of large scale integration (LSI).

As a result of recent developments in fine machining techniques, complementary (C) MOS (metal-oxide semiconductor) transistors are driven by a source voltage which is changed from a 5-volt series to a 3-volt series. This is because an electric field intensity at a gate oxide film for use as a reference of a device reliability is, for example, 5 MV/cm and is exceeded when a voltage of 5 volts is applied across a gate electrode and a source or a drain electrode of a p-channel or n-channel type MOS field effect transistor (FET) which has a gate length of 0.8 micrometer or shorter and a gate oxide film thickness of 15 nm or thinner. If the reference for the device reliability is exceeded, a gate current would undesiredly flow. Although prevented from flowing when the field intensity is reduced, the the gate current gives rise to a lattice defect, if once allowed to flow, to deteriorate the device reliability. Use of the low voltage is mandatory so as not to bring forth such a defect. As a consequence, the interface circuit is indispensable between the first and the second integrated circuits.

The first integrated circuit deals with first input and output signals of a first swing of 5 volts. The second integrated circuit processes second input and output signals of a second swing of 3 volts. Put in operation by the source voltage of the 3-volt series, the interface circuit converts the second output signal to the first input signal. In this event, the first input signal must have a high voltage level which is of the 5-volt series and is sufficiently higher than a first input threshold level of the first integrated circuit. Otherwise, misoperation is liable to take place in the first integrated circuit. Furthermone, a feed-through current would flow through a first input stage of the first integrated circuit. The interface circuit must moreover convert the first output signal to the second input signal. In this latter event, the inferface circuit must make it sure to avoid application of a 5-volt signal to a second input stage of the second integrated circuit. This is important to insure a reliable operation of the second integrated circuit.

In the manner which will later be described in greater detail, a conventional interface circuit has an interface input terminal for connection to a first output stage of the first integrated circuit and an interface output terminal connected to the second integrated circuit. Having the input terminal, the interface circuit is operable as the second input stage for the second integrated circuit. Connected to the second integrated circuit, the interface circuit is operable as a second output stage for the second integrated circuit.

The interface circuit comprises a plurality of MOS field effect transistors of p-channel and n-channel types. Merely for brevity of the description, the MOS field effect transistors of the p-channel and the n-channel types will be referred to simply as a p-channel type and an n-channel type transistors The high voltage is obtained from a first power source of a first source voltage. Likewise, a second power source gives the low voltage as a second source voltage.

In order to convert the second output signal to the first input signal, the second output stage comprises a p-channel and an n-channel type transistor connected in series across the second power source. An n-channel type transistor is connected to a point of series connection of the p-channel and the n-channel type transistors and to an output signal lead connected to the first input stage to cope with the second output signal having a full swing of 3 volts. The first input stage comprises a p-channel and an n-channel type transistor connected in series across the first power source with their gate electrodes connected to the output signal lead. A pull-up resistor is connected to the output signal lead to pull up the 3-volt full swing to provide the first input signal with a 5-volt full swing.

In the manner described in the foregoing, the second output stage stably provides the first input signal at a point of connection between the output signal lead and the first input stage. This prevents the first integrated circuit from misoperation and the feed-through current from flowing through the gate electrodes of the first input stage.

In order to convert the first output signal to the second input signal, the second input stage comprises a p-channel and an n-channel type transistor connected in series across the second power source. A point of series connection of the p-channel and the n-channel type transistors is for producing an interface output signal as the second input signal for delivery to the second integrated circuit. An n-channel type transistor is connected to the interface input terminal and to gate electrodes of the p-channel and the n-channel type transistors. The interface input terminal is connected to an input signal lead which is connected, in turn, to the first output stage to deliver the first output signal to the interface circuit as an interface input signal with the 5-volt full swing.

It is to be noted that the interface circuit is operable with the low voltage like the second integrated circuit. The n-channel type transistor is therefore given a threshold value or level of 0 volt in order to deal with the 3-volt full swing. This prevents application of a potential difference of 5 volts across a gate electrode and a source or a drain electrode of each of the transistors used in the interface circuit and in the second integrated circuit. The first output signal of the 5-volt series is successfully converted to the second input signal of the 3-volt series.

It has now been confirmed by the present inventor in connection with the first output stage and the second input stage that duty ratios are different. This results from the fact that the first input and the first output stages and the second input stage have the first and the second input threshold levels which are different from each other. As a consequence, timing of a clock-type signal is different between the first and the second integrated circuits when supplied from the first integrated circuit to the second integrated circuit. This prevents the integrated circuit device from operating at a high speed and renders a margin for device design narrow.

In Japanese Patent Prepublication (A) No. 250716 of 1992, an input/output circuit is disclosed for adjusting an input threshold level of a CMOS circuit in a plurality of stages. Like in the second input stage described above, the CMOS circuit comprises a p-channel and an n-channel type transistor connected in series as first and second transistors with their gate electrodes supplied with a circuit input signal. As a third transistor, an n-channel type transistor is connected to the second transistor in series and to ground with its gate electrode supplied with a control signal for adjusting the input threshold level. If this input/outpot circuit is used in the interface circuit being described, the first output signal is supplied directly to the gate electrodes of the first and the second transistors. It has been confirmed that this circuit is not applicable here.

SUMMARY OF THE INVENTION:

It is consequently an object of the present invention to provide a semiconductor integrated circuit device connected to a first integrated circuit operable with a high voltage and comprises a second integrated circuit operable with a low voltage and an interface circuit which is operable with the low voltage and is capable of preventing a signal current having a full swing of the high voltage from flowing through transistors therein and in the second integrated circuit.

It is another object of this invention to provide a semiconductor integrated circuit device which is of the type described and in which a field intensity never exceeds a reference for device reliability in a gate oxide film of each of the transistors to insure appearance of no deterioration in the device reliability.

It is still another object of this invention to provide a semiconductor integrated circuit device which is of the type described and in which an output signal of the first integrated circuit and an input signal of the second integrated circuit have a substantially common duty ratio.

It is yet another object of this invention to provide a semiconductor integrated circuit device which is of the type described and which can be designed with a wide margin to be stably operable at a high speed.

Other objects of this invention will become clear as the description proceeds.

In accordance with an aspect of this invention, there is provided a semiconductor integrated circuit device connected to a first semiconductor integrated circuit operable with a first source voltage and comprising a second semiconductor integrated circuit operable with a second source voltage and an interface circuit having an input and an output terminal connected to the first semiconductor integrated circuit and to the second semiconductor integrated circuit, the first source voltage being higher than the second source voltage, the second source voltage having an upper and a lower voltage limit, wherein the interface circuit comprises: (A) first and second MOS field effect transistors connected in series and supplied with the upper voltage limit and with the lower voltage limit; (B) an n-channel type MOS field effect transistor connected between the input terminal and gate electrodes of the first and the second MOS field effect transistors and having a gate electrode supplied with a local voltage which is not higher than the upper voltage limit; and (C) a third MOS field effect transistor having a channel type of the first MOS field effect transistor and connected in parallel to the first MOS field effect transistor and to the output terminal.

In accordance with a different aspect of this invention, there is provided a semiconductor integrated circuit device connected to a first semiconductor integrated circuit operable with a first source voltage and comprising a second semiconductor integrated circuit operable with a second source voltage and an interface circuit having an input and an output terminal connected to the first semiconductor integrated circuit and to the second semiconductor integrated circuit, the first source voltage being higher than the second source voltage, the second source voltage having an upper and a lower voltage limit, wherein the interface circuit comprises: (A) first and second MOS field effect transistors connected in series with the first MOS field effect transistor supplied with the upper voltage limit and with a point of series connection connected to the output terminal; (B) an n-channel type MOS field effect transistor connected between the input terminal and gate electrodes of the first and the second MOS field effect transistors and having a gate electrode supplied with a local voltage which is not higher than the upper voltage limit; and (C) a third MOS field effect transistor having a channel type of the second MOS field effect transistor, connected in series to the second MOS field effect transistor, and supplied with the lower voltage limit.

In accordance with a further different aspect of this invention, there is provided a semiconductor integrated circuit device comprising a plurality of MOS field effect transistors on a semiconductor chip, input and output terminals on the semiconductor chip with the input terminal connected to a first semiconductor integrated circuit operable with a first source voltage, first and second terminals supplied on the semiconductor chip with an upper and a lower voltage limit of a second source voltage, and wirings on the semiconductor chip for connecting selected ones of the MOS field effect transistors to form a second semiconductor integrated circuit connected to the output terminal and between the first and the second terminals and to leave others of the MOS field effect transistors, the first source voltage being higher than the second source voltage, wherein: (A) the others of MOS field effect transistors comprise first and second MOS field effect transistors of a p-channel and an n-channel type, an input MOS field effect transistor having the n-channel type and a threshold value of substantially 0 volt, and a third MOS field effect transistor of the p-channel type; (B) the semiconductor integrated circuit device further comprising additional wirings connecting on the semiconductor chip the first and the second MOS field effect transistors in series between the first and the second terminals, the input MOS field effect transistor between the input terminal and gate electrodes of the first and the second MOS field effect transistors and with a gate electrode of the input MOS field effect transistor supplied with a local voltage which is not higher than the upper voltage limit, and the first and the third MOS field effect transistors in parallel with a point of parallel connection connected to the output terminal.

In accordance with a still further different aspect of this invention, there is provided a semiconductor integrated circuit device comprising a plurality of MOS field effect transistors on a semiconductor chip, input and output terminals on the semiconductor chip with the input terminal connected to a first semiconductor integrated circuit operable with a first source voltage, first and second terminals supplied on the semiconductor chip with an upper and a lower voltage limit of a second source voltage, and wirings on the semiconductor chip for connecting selected ones of the MOS field effect transistors to form a second semiconductor integrated circuit connected to the output terminal and between the first and the second terminals and to leave others of the MOS field effect transistors, the first source voltage being higher than the second source voltage, wherein: (A) the others of MOS field effect transistors comprise first and second MOS field effect transistors of a p-channel and an n-channel type, an input MOS field effect transistor having the n-channel type and a threshold value of substantially 0 volt, and a third MOS field effect transistor of the n-channel type; (B) the semiconductor integrated circuit device further comprising additional wirings connecting on the semiconductor chip the first MOS field effect transistor between the first terminal and the output terminal, the second and the third MOS field effect transistors in series betweeen the output terminal and the second terminal, and the input MOS field effect transistor between the input terminal and gate electrodes of the first through the third MOS field effect transistors with a gate electrode of the input MOS field effect transistor supplied with a local voltage which is not higher than the upper voltage limit.

BRIEF DESCRIPTION OF THE DRAWING:

Fig. 1 is a circuit diagram of a prior art semiconductor integrated circuit device known by the present inventor;

Fig. 2 shows characteristics of the semiconductor integrated circuit device illustrated in Fig. 1;

Fig. 3 is a circuit diagram of a semiconductor integrated circuit device according to a first embodiment of the instant invention; and

Fig. 4 is a partial circuit diagram of a semiconductor integrated circuit device according to a second embodiment of this invention.

DESCRIPTION OF THE PREFERRED EMBODIMENTS:

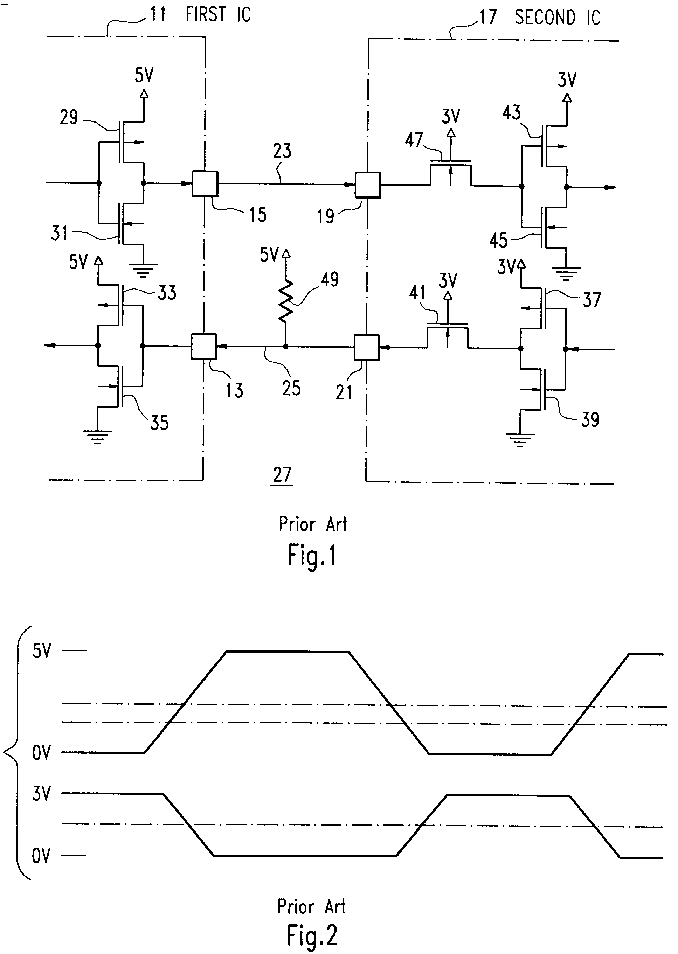

Referring to Figs. 1 and 2, a prior art semiconductor integrated circuit device will first be described in order to facilitate an under standing of the present invention. This semiconductor integrated circuit device is known by the present inventor.

In Fig. 1, the integrated circuit device comprises a first integrated circuit 11 operable with a first power source of a first source voltage, which is typically 5 volts. The first integrated circuit 11 has first circuit input and output terminals 13 and 15. A second integrated circuit 17 is operable with a second power source of a second source voltage which is lower than the first source voltage and is typically 3 volts. The second integrated circuit 17 has second input and output teriminals 19 and 21 connected through an input signal lead 23 to the first circuit output terminal 15 and through an output signal lead 25 to the first circuit input terminal 13.

The first source voltage has first upper and lower voltage limits. The second power source has higher and lower voltage ends or terminals at which the second source voltage has second upper and lower voltage limits. Ordinarily, the first and the second lower voltage limits are given by ground (G) and are depicted as such. The first and the second upper voltage limits are indicated by 5 V and 3 V.

The integrated circuit device comprises a plurality of MOS (metal-oxide semiconductor) field effect transistors (FET's) on a semiconductor chip or substrate 27. Each of such transistors comprises a gate, a source, and a drain electrode and a gate oxide film interposed between the gate electrode and the source and the drain electrodes. Some and different ones of the MOS field effect transistors are of a p-channel and an n-channel type, The MOS field effect transistors of the p-channel and the n-channel types will be referred to simply as p-channel and n-channel type transistors.

In the second integrated circuit 17, each p-channel type transistor has a gate length LP and a gate oxide film thickness. Each n-channel type transistor has a gate length LN and a gate oxide film thickness. The gate length LP or LN is 0.8 micrometer or shorter. The gate oxide film thickness is 15 nm or thinner. The transistors are consequently driven by a source voltage of a 3-volt series, If a signal of a 5-volt series were supplied across the gate oxide film, an electric field intensity would exceed at the gate oxide film a reference for device reliability of, for example, 5 MV/cm. This would bring about various defects described hereinabove.

The first integrated circuit 11 produces a first circuit output signal at the first circuit output terminal 15. As a first circuit input signal, the second integrated circuit 17 delivers a second circuit output signal through the second circuit output terminal 21 and the output signal lead 25 to the first circuit input terminal 13. Through the input signal lead 23, the first circuit output signal is supplied to the second input terminal 19 as a second circuit input signal.

The first integrated circuit 11 comprises a first output stage comprising p-channel and n-channel type first output stage transistors 29 and 31 connected in series and supplied with the first upper and lower voltage limits. The first output signal is produced at a point of this series connection. A first input stage comprises p-channel and n-channel type first input stage transistors 33 and 35 connected in series and supplied with the first upper and lower voltage limits. The first input signal is supplied to a point of this latter series connection.

The second integrated circuit 17 comprises a second output stage comprising p-channel and n-channel type second output stage transistors 37 and 39 connected in series between the higher and the lower voltage ends and an n-channel type output transistor 41 connected between the second output terminal 21 and a point of this series connection and having the gate electrode connected to the higher voltage end. A second input stage comprises p-channel and n-channel type second input stage transistors 43 and 45 connected is series between the higher and the lower voltage ends and an n-channel type input trensistor 47 connected between the second input terminal 19 and the gate electrodes of the second input stage transistors 43 and 45 and having the gate electrode connected to the higher voltage end. By adjusting an impurity concentration in the semiconductor substrate 27, each of the input and the output transistors 47 and 41 is given a threshold value or level of substantially 0 volt.

The output signal lead 25 is supplied through a pull-up resistor 49 with the first upper voltage limit of 5 volts relative to ground. It is possible in this manner to keep the first and the second integrated circuits 11 and 17 optimally operable inch the manner described hereinabove.

It has, however, been found as will be described in conjunction with Fig. 2 that this integrated circuit device has defects. In the first integrated circuit 11, the transistors, such as 29 to 35, are operable with a first input threshold level of about 2.5 volts. The second integrated circuit 17 comprises a main body in which use is made of p-channel and n-channel type transistors operable with a second input threshold level of about 1.5 volts. The second output stage is supplied with an internal output signal from the main body at a point of series connection of the transistors 37 and 39. The second input stage delivers an internal input signal to the main body from a point of series connection of the transistors 43 and 45. Attention will now be directed to the second input stage.

Usually, the first integrated circuit 11 deals with signals having a first full swing of the first source voltage of 5 volts to vary between the first upper and lower voltage limits. The main body processes signals having a second full swing of the second source voltage of 3 volts to vary between the second upper and lower voltage limits. In the manner described before, the first and the second lower voltage limits are given by ground, namely, are 0 volt.

In Fig. 2, the first circuit output signal is exemplified along an upper row. The internal input signal is depicted along a lower row. It will be presumed that the first circuit output signal has a first duty ratio of 1 : 1. The first input threshold level is depicted along the upper row by a dash-dot line. The second input threshold level is depicted along the upper and the lower rows by dash-two-dot lines. Due to a difference between the first and the second input threshold level, the internal input signal has a second duty ratio which is different from 1 : 1. This adversely affects high speed operation of the first and the second integrated circuits 11 and 17 and a margin of design of the integrated circuit device.

Referring now to Fig, 3, the description will proceed to a semiconductor integrated circuit device according to a first embodiment of this invention. The above-described main body is afresh referred to as a second integrated circuit 17, which is typically a logic circuit. The second circuit input and output terminals are called an interface input terminal 19 and an interface output terminal (not herein shown). The internal input and output terminals are afresh called a second circuit input terminal 51 and a second circuit output terminal (not herein depicted). Between the interface output terminal and the second circuit output terminal and between the interface input terminal 19 and the second circuit input terminal 51, which serves as a different interface output terminal, circuitry is now called an interface circuit. The integrated circuit device comprises the interface circuit and the second integrated circuit 17. Depending on the circumstances, the integrated circuit device may further comprise the first integrated circuit 11 described in conjunction with Fig. 1.

The interface circuit comprises interface input and output stages. The interface output stage is similar in structure and operation to the second circuit output stage described in the foregoing. Being not much different from the second circuit input stage described before, the interface input stage comprises the p-channel and the n-channel type transistors which are now referred to as first and second (MOS field effect) transistors 43 and 45. In the example being illustrated, the gate electrodes of the input transistor 47 is supplied with a local voltage VDD which is not higher than the upper voltage limit, namely, 3 volts relative to the lower voltage limit of ground or 0 volt, of the second source voltage.

The first circuit output signal is supplied through the input signal lead 23 (Fig. 1) to the interface input terminal 19 as an interface input signal. The interface input stage produces an interface output signal at the different interface output terminal 51, which is now afresh referred to simply as an interface output terminal 51. The local voltage is preferably equal to the upper voltage limit. Alternatively, the local voltage may be lower and should not be lower than about a half of the first source voltage of 5 volts.

Connected in parallel to the first transistor 43 is a third (MOS field effect) transistor 53 which is of the p-channel type. Parallel connection of the p-channel type transistors 43 and 53 renders a mutual conductance gm great. In other words, a great drain current flows through the parallel connection even when a low voltage is applied across the gate and the source electrodes as a gate-source voltage. A plurality of similar p-channel type transistors may be used collectively as the third transistor 53 to further raise the mutual conductance.

It will now be assumed in connection with a converter circuit composed of a p-channel and an n-channel type transistor and connected between an upper and a lower voltage limit of a source voltage that a feed-through current flows through the converter circuit with no change at a transition point of the converter circuit even when a plurality of parallel connected p-channel type transistors are used instead of a single p-channel type transister. This is because the n-channel type transistor serves as a current limiter. If the mutual conductance is great, the feed-through current of a predetermined value flows when the gate-source voltage is low. That is, a shift towards the upper voltage limit takes place in the input threshold level which is an input unit voltage at the transition point.

More particularly, let the gate length LP or LN be 0.5 micrometer and a gate width WP or WN be 10 micrometers, If the third transistor 53 is only one in number, the input threshold level is raised by about 0.1 volt as compared with a case where use is not made of the third transistor 53. Strictly speaking, the duty ratio depends on time intervals of build up and down of the first circuit output signal. If these time intervals are equal to 1.0 volt/ns and 0.5 volt/ns, a variation takes place in a pulse width between the first circuit output signal and the interface input signal as follows.

$$0.1/1 + 0.1/0.5 = 0.3 \ (ns).$$

It is now understood with respect to the duty ratio described in connection with Fig. 2 that the second duty ratio is improved by 0.3 ns towards the first duty ratio.

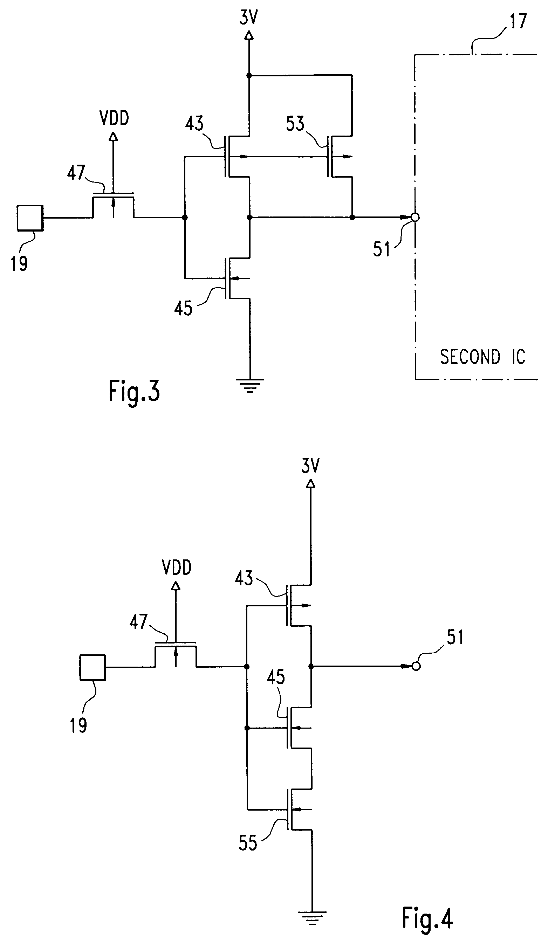

Turning to Fig. 4, attention will be directed to a semiconductor integrated circuit device according to a second embodiment of this invention. In the integrated circuit device, an interface circuit is similar in structure to that illustrated with reference to Fig. 3.

Use is, however, made instead of the p-channel type third transistor 53 described in conjunction with Fig. 3 of an n-channel type transistor as a third (MOS field effect) transistor 55 and is connected to the second transistor 45 in series and to the lower voltage end of the second power source. A point of this series connection is connected to the inferface output terminal 51. A plurality of similar n-channel type transistors may by used collectively as the third transistor 55. The input transistor 47 is connected between the interface input terminal 19 and the gate electrodes of the first through the third transistors 43, 45, and 55.

Like the parallel connection of the p-channel type transistors described in conjunction with Fig. 3, the series connection of a plurality of n-channel type transistors 45 and 55 results in a decrease in the mutual conductance to raise the gate-source voltage necessary for a predetermined drain current because of operation of the p-channel type transistor 43 as a current limiter. This eventually results in a shift of the input threshold level towards the upper voltage limit.

When the third transistor 55 is only one in number and furthermore when the gate length and the gate width are as exemplified in the foregoing, the input threshold level is raised by about 0.2 volt. If the build up and down time intervals are as assumed above, the second duty ratio is improved by 0.6 ns towards the first duty ratio because:

$$0.2/1 + 0.2/0.5 = 0.6 \ (ns).$$

Reviewing Figs. 3 and 4, the input transistor 47 should be of the n-channel type. If a p-channel type transistor were used, an electric current would undesiredly flow into an n-type well which is connected to a p-type diffusion layer of the interface input terminal 19 of a bonding pad type and is supplied with the local voltage when a signal is supplied to the interface input terminal 19 with the first source voltage of 5 volts.

Furthermore, it may be mentioned here that the first integrated circuit 11 of Fig. 3 may comprise a plurality of integrated circuits individually operable with the first power source. The second integrated circuit 17 may be used in common to such integrated circuits. Under the circumstances, the second integrated circuit 17 is formed centrally of the semiconductor chip 27 of Fig. 1 with the plurality of integrated circuits formed peripherally and with interface circuits of Fig. 3 or 4 interposed between the second integrated circuit 17 and the integrated circuits arranged peripherally. Such interface circuits serves as switching circuits connected to the second integrated circuit 17 and to the peripherally disposed integrated circuits by external leads.

Reviewing Fig. 3 with Fig. 1 additionally referred to, the semiconductor integrated circuit device may be a CMOS integrated circuit device comprising a plurality of (MOS field effect) transistors formed on a semiconductor substrate 27 of a master slice type. Similar parts will be designated by like reference numerals. It will be presumed that the integrated circuit device comprises the second integrated circuit 17 and the interface circuit.

At predetermined positions on the semiconductor substrate 27, formed are the interface input and output terminals 19 and 51 and first and second terminals for connection to the higher and the lower voltage ends of the second power source for supply of the upper and the lower voltage limits of 3 volts and ground of the second source voltage. The interface input terminal 19 is for connection to the first integrated circuit 11 to be supplied with the first circuit output signal of the 5-volt series.

With at least one insulator film interposed in the manner known in the art, wirings are formed on the semiconductor substrate 27 to connect selected ones of the transistors into the second integrated circuit 17. Others of the plurality of transistors are left as other transistors. The other transistors comprise first and second transistors 43 and 45 of the p-channel and the n-channel types, an input transistor 47 having the n-channel type and a threshold value of substantially 0 volt, and a third transistor 53 of the p-channel type. It is necessary to additionally form the input transistor 47 if such a transistor is not available among the other transistors.

With the at least one insulator film formed im common, additional wirings are formed on the semiconductor substrate 27 to connect the first and the second transistors 43 and 45 in series to the first and the second terminals, the input transistor 47 to the input terminal 19 and to the gate electrodes of the first and the second transistors 43 and 45, and the first and the third transistors 43 and 53 in parallel with a point of this parallel connection connected to the output terminal 51. The gate electrode of the input transistor 47 is connected either to the first terminal or to a different terminal which is preveiously formed on the semiconductor substrate 27 for supply thereto of of the local voltage VDD. The output terminal 51 may be a specific point of the second integrated circuit 17 at which point the interface output signal is delivered.

Reviewing now Fig. 4 with Fig. 1 continuously referred to, the semiconductor integrated circuit device may be a similar CMOS integrated circuit device. From the other transistors described above, an n-channel type (MOS field effect) transistor is selected as a third transistor 55. This third transistor 55 may be a plurality of similar transistors.

The additional wirings are used to connect the first through the third transistors 43, 45, and 55 successively in series between the first and the second terminals, the input transistor 47 to the input terminal 19 and to the gate electrodes of the first through the third transistors 43, 45, and 55, and the output terminal 51 to a point of series connection of the first and the second transistors 43 and 45. The third transistors 55 are connected in series when used collectively as the third transistor 55.

## Claims

1. A semiconductor integrated circuit device connected to a first semiconductor integrated circuit (11) operable with a first power source of a first source voltage and comprising a second semiconductor integrated circuit (17) operable with a second power source of a second source voltage and an interface circuit having an input (19) and an output (51) terminal connected to said first semiconductor integrated circuit and to said second semiconductor integrated circuit and comprising first (43) and second (45) MOS field effect transistors connected in series across said second power source, said first source voltage being higher than said second source voltage, said second power source having a higher and a lower voltage end, wherein said interface circuit comprises:

   an n-channel type MOS field effect transistor (47) connected between said input terminal and gate electrodes of said first and said second MOS field effect transistors and having a gate electrode supplied with a local voltage which is not higher in voltage than said higher voltage end; and

   a third MOS field effect transistor (53) having a channel type of said first MOS field effect transistor and connected to said first MOS field effect transistor in parallel and to said output terminal.

2. A semiconductor integrated circuit device connected to a first semiconductor integrated circuit (11) operable with a first power source of a first source voltage and comprising a second semiconductor integrated circuit (17) operable with a second power source of a second source voltage and an interface circuit having an input (19) and an output (51) terminal connected to said first semiconductor integrated circuit and to said second semiconductor integrated circuit and comprising first (43), second (45), and third (55) MOS field effect transistors connected successively in series across said second power source, said second and said third MOS field effect transistors having a common channel type, said first source voltage being higher than said second source voltage, said second power source having a higher and a lower voltage end, wherein:

   said interface circuit comprises an n-channel type MOS field effect transistor (47) connected between said input terminal and gate electrodes of said first through said third MOS field effect transistors and having a gate electrode supplied with a local voltage which is not higher in voltage than said higher voltage end;

   a point of series connection between said first and said second MOS field effect transistors being connected to said output terminal.

3. A semiconductor integrated circuit device comprising a plurality of MOS field effect transistors on a semiconductor chip, input (19) and output (51) terminals on said semiconductor chip with said input terminal connected to a first semiconductor integrated circuit (11) operable with a first power source of a first source voltage, first (3 V) and second (G) terminals connected on said semiconductor chip to a higher and a lower voltage end of a second power source of a second source voltage, and wirings on said semiconductor chip for connecting selected ones of said MOS field effect transistors to form a second semiconductor integrated circuit (17) connected to said output terminal and to said first and said second terminals and to leave others of said MOS field effect transistors, wherein:

said others of MOS field effect transistors comprise first (43) and second (45) MOS field effect transistors of a p-channel and an n-channel type, an input MOS field effect transistor (47) having said n-channel type and a threshold value of substantially 0 volt, and a third MOS field effect transistor (53) of said p-channel type;

said semiconductor integrated circuit device further comprising additional wirings connecting on said semiconductor chip said first and said second MOS field effect transistors in series between said first and said second terminals, said input MOS field effect transistor between said input terminal and gate electrodes of said first and said second MOS field effect transistors with a gate electrode of said input MOS field effect transistor supplied with a local voltage which is not higher in voltage than said higher voltage end, and said first and said third MOS field effect transistors in parallel with a point of parallel connection connected to said output terminal.

4. A semiconductor integrated circuit device comprising a plurality of MOS field effect transistors on a semiconductor chip, input (19) and output (51) terminals on said semiconductor chip with said input terminal connected to a first semiconductor integrated circuit (11) operable with a first power source of a first source voltage, first (3 V) and second (G) terminals connected on said semiconductor chip to a higher and a lower voltage end of a second power source of a second source voltage, and wirings on said semiconductor ship for connecting selected ones of said MOS field effect transistors to form a second semiconductor integrated circuit (17) connected to said output terminal and to said first and said second terminals and to leave others of said MOS field effect transistors, wherein:

said others of MOS field effect transistors comprise first (43), second (45), and third (55) MOS field effect transistors of a p-channel, an n-channel, and said n-channel type and an input MOS field effect transistor (47) having said n-channel type and a threshold value of substantially 0 volt;

said semiconductor integrated circuit device further comprising additional wirings connecting on said semiconductor chip said first through said third MOS field effect transistors successively in series between said first and said second terminals, said input MOS field effect transistor between said input terminal and gate electrodes of said first through said third MOS field effect transistors, and said output terminal to a point of series connection between said first and said second MOS field effect transistors.

5. A semiconductor integrated circuit device as claimed in any one of Claims 1 to 4, characterised in that said local voltage is equal in voltage to said higher voltage end.

6. A semiconductor integrated circuit device as claimed in any one of Claims 1 to 4, said second source voltage being not lower than a half of said first source voltage, characterised in that said local voltage is not lower than about said half.

7. A semiconductor integrated circuit device as claimed in any one of Claims 1 to 4, characterised in that said first and said second source voltages are 5 and 3 volts.

EP 0 690 578 A1

Prior Art

Fig.1

Prior Art

Fig.2

3V

17

VDD

43      53

47

19      45      51

SECOND IC

**Fig.3**

3V

VDD

43

47      51

19      45

55

**Fig.4**

European Patent
Office

**EUROPEAN SEARCH REPORT**

Application Number

EP 95 10 8328

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | EP-A-0 323 643 (KABUSHIKI KAISHA TOSHIBA) * column 4, line 35 - column 6, line 16; figure 1 * | 1-4 | H03K19/0185 |
| A | IBM TECHNICAL DISCLOSURE BULLETIN, vol.29, no.12, May 1987 page 5167 'Fast Level Converter Circuit' * the whole document * | 1-4 | |
| A | RESEARCH DISCLOSURE, no.299, March 1989, NEW YORK, US page 168 'Low Power Receiver for Interfacing a 5 Volt Input Signal with a 3,4 Volt Chip' * the whole document * | 1-4 | |
| P,A | US-A-5 319 259 (R. B. MERRILL) * abstract; figure 9 * | 1-4 | |
| P,A | US-A-5 378 945 (H. PARTOVI ET AL) * figures 1-3 * | 1-4 | TECHNICAL FIELDS SEARCHED (Int.Cl.6) |
| A | PATENT ABSTRACTS OF JAPAN vol. 5, no. 103 (E-064) 3 July 1981 & JP-A-56 046 339 (HITACHI LTD) 27 April 1981 * abstract * | | H03K |
| A | PATENT ABSTRACTS OF JAPAN vol. 16, no. 392 (E-1251) 20 August 1992 & JP-A-04 129 319 (NEC CORP) 30 April 1992 * abstract * | | |
| | -/-- | | |

The present search report has been drawn up for all claims

| Place of search | Date of completion of the search | Examiner |
|---|---|---|
| BERLIN | 13 September 1995 | Arendt, M |

| European Patent Office | EUROPEAN SEARCH REPORT | Application Number EP 95 10 8328 |
|---|---|---|

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| P,A | PATENT ABSTRACTS OF JAPAN vol. 18, no. 593 (E-1629) 11 November 1994 & JP-A-06 224 700 (TOSHIBA CORP) 12 August 1994 * abstract * | | |
| D,A | PATENT ABSTRACTS OF JAPAN vol. 17, no. 28 (E-1308) 19 January 1993 & JP-A-04 250 716 (NIPPON STEEL CORP) 7 September 1992 * abstract * | | |

TECHNICAL FIELDS SEARCHED (Int.Cl.6)

The present search report has been drawn up for all claims

| Place of search | Date of completion of the search | Examiner |
|---|---|---|
| BERLIN | 13 September 1995 | Arendt, M |